# EUROPEAN PATENT APPLICATION

(11) **EP 4 601 074 A1**
(43) Date of publication of application: **13.08.2025**
(21) Application number: 23950517.5
(22) Date of filing: 07.12.2023
(51) Int. Cl.: H01M 10/48, H01M 50/569, G01R 31/378

(54) **POWER BATTERY, AND HEALTH EVALUATION METHOD AND HEALTH EVALUATION APPARATUS THEREFOR**

(30) Priority: 31.08.2023 CN 202311125555
(71) Applicant: Eve Power Co., Ltd., Jingmen, Hubei 448000 (CN)
(72) Inventor: FAN, Guiping, Jingmen, Hubei 448000 (CN); QIN, Jingping, Jingmen, Hubei 448000 (CN)
(74) Representative: Herrero & Asociados, S.L.
(86) International application number: PCT/CN2023/137276
(87) International publication number: WO 2025/043949

(57) **Abstract**

The present disclosure relates to a power battery, a health evaluation method and a health evaluation device thereof. The power battery includes a cell, an expansion force sensor and an electrode sheet sensor. The cell includes electrode sheets. The expansion force sensor is electrically connected to the cell, and is configured to collect expansion forces at different thickness positions of the cell, and assess a health state of the power battery according to the expansion forces. The electrode sheet sensor is electrically connected to the cell, and is configured to collect the thicknesses of the electrode sheets at different thickness positions of the cell, and assess the health state of the power battery according to the thicknesses of the electrode sheets.

## Description

The present disclosure claims priority to Chinese Patent Application No. 202311125555.4, filed with the Chinese Patent Office on August 31, 2023, the disclosure of which is incorporated herein by reference in its entirety.

### TECHNICAL FIELD

The present disclosure relates to the technical field of batteries, and for example, to a power battery, a health evaluation method and a health evaluation device thereof.

### BACKGROUND

With the rapid development of new energy vehicle markets, power batteries also are also experiencing well-spray development. At present, standards and specifications related to power battery systems have been formulated, and the country has also formulated corresponding subsidy policies. It has become a potential trend to rapidly promote the development of power batteries. The power batteries have been widely used in the fields of power, energy storage, and commercial vehicles. During the use of cells of a power battery, problems such as over-charging, over-discharging, short-circuiting, extrusion, overheating, etc. may occur, leading to safety accidents caused by the failure of the cells. Therefore, it is of great significance to monitor the health state of the cells in real time, predict the runaway of the cells in advance, and issue alarms. At present, there is a great lack of real-time intelligent monitoring solutions for the health state of cells in the industry, which poses a great potential safety hazard to cells during use.

### TECHNICAL PROBLEM

The present disclosure provides a power battery, a health evaluation method and a health evaluation device of the power battery, which can monitor expansion force of cells and change in the thickness of electrodes, thereby monitoring the safety state of the cells and reducing the safety risk of the cells.

### TECHNICAL SOLUTION

According to a first aspect, the embodiments of the present disclosure provides a power battery. The power battery includes a cell, an expansion force sensor, and an electrode sheet sensor; where,
the cell includes electrode sheets;
the expansion force sensor is electrically connected to the cell, and is configured to collect expansion forces at different thickness positions of the cell, and assess a health state of the power battery according to the expansion forces;
the electrode sheet sensor is electrically connected to the cell, and is configured to collect the thickness of the electrode sheet at different thickness positionsof the cell, and assess the health state of the power battery according to the thickness of the electrode sheets.

According to a second aspect, the embodiments of the present disclosure further provides a health evaluation method of a power battery. The power battery includes the foregoing power battery. The health evaluation method includes:
collecting, by an expansion force sensor, expansion forces at different thickness positions of a cell of the power battery, and assessing a health state of the power battery according to the expansion forces;
collecting, by an electrode sheet sensor, thickness of electrode sheets at different thickness positions of the cell, and assessing the health state of the power battery according to the thickness of the electrode sheets; and
further evaluating, by a processor, the health state of the power cell according to assessment results of the expansion force sensor and the electrode sheet sensor.

According to a third aspect, the embodiments of the present disclosure further provide a health evaluation device of a power battery. The power battery includes the power battery described above. The health evaluation device includes a processor. The processor is configured to further evaluate the health state of the power battery according to assessment results of the expansion force sensor and the electrode sheet sensor.

### BENEFICIAL EFFECTS

Beneficial effects of the present disclosure are as follows: The above introduces a power battery, a health evaluation method and a health evaluation device of the power battery. The power battery includes: the power battery including a cell, an expansion force sensor and an electrode sheet sensor. The cell includes electrode sheets. The expansion force sensor is electrically connected to the cell, and is configured to collect expansion forces at different thickness positions of the cell, and assess a health state of the power battery according to the expansion forces. The electrode sheet sensor is electrically connected to the cell, and is configured to collect the thickness of the electrode sheet at different thickness positions of the cell, and assess the health state of the power battery according to the thickness of the electrode sheet. Therefore, the expansion forces and the thickness of the electrode sheets of the cell at different thickness positions of the cell can be respectively collected by a plurality of sensors to evaluate the health state of the battery, so that the safety state of the cell can be monitored in real time and comprehensively, thereby reducing a safety risk of the cell.

### BRIEF DESCRIPTION OF THE DRAWINGS

FIG. 1 is a schematic diagram of a front view structure of a power battery according to embodiments of the present disclosure;
FIG. 2 is a schematic diagram of one side structure of the power battery shown in FIG. 1;
FIG. 3 is a schematic diagram of a fixed structure of an electrode sheet sensor of the power battery shown in FIG. 2;
FIG. 4 is a schematic diagram of another side structure of the power battery shown in FIG. 1;
FIG. 5 is a schematic flowchart of a health evaluation method of a power battery according to embodiments of the present disclosure;
FIG. 6 is a schematic block diagram of a health evaluation device of a power battery according to embodiments of the present disclosure.

Reference numerals in the embodiments of the present disclosure are described as follows:
100, power battery; 11, cell pack; 12, expansion force sensor; 13, electrode sheet sensor; 111, cell; 112, tab; 14, housing; 121, first collection harness; 1213, first sampling harness; 1211, first winding harness; 1212, first transmission harness; 141, top surface; 142, first side surface; 143, second side surface; 112, one-eighth thickness position; 113, three-eighth thickness position; 114, five-eighth thickness position 114; 115, seven-eighth thickness position; 116, central line position; 1211A, 1211B, and 1211C, winding wires; 150, high temperature adhesive tape; 131, second collection harness; 1311, second winding harness; 1312, second sampling harness; 1313, second transmission harness; 1311A, 1311B and 1311C, winding wires; 140, high temperature adhesive tape; 144, liquid injection hole; 145, positive pole; 146, negative pole; 147, circular hole; 21, processor.

### DETAILED DESCRIPTION

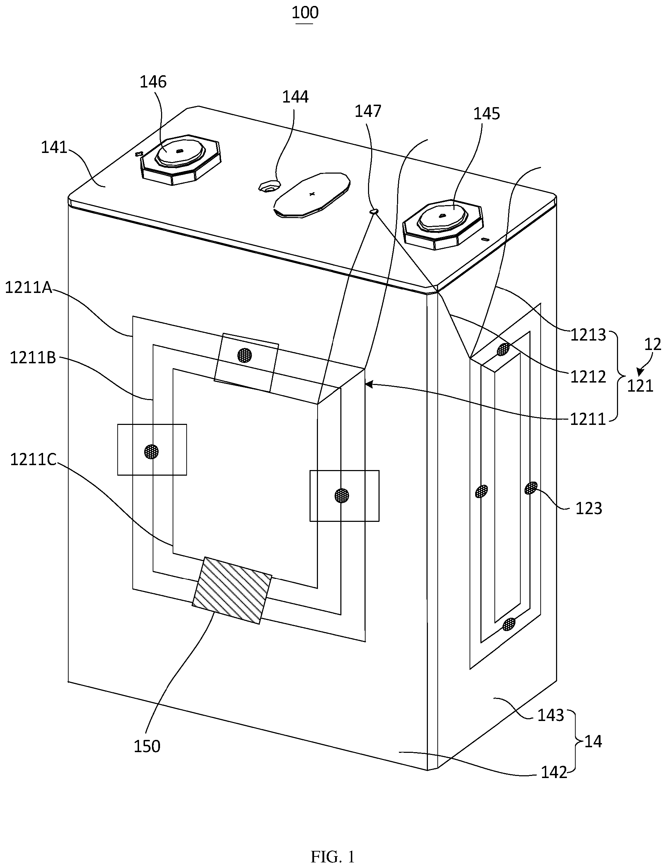

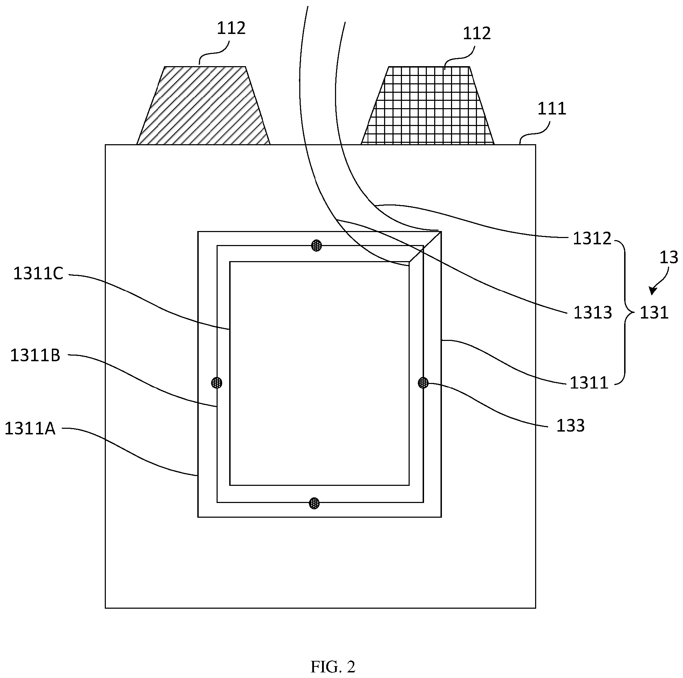

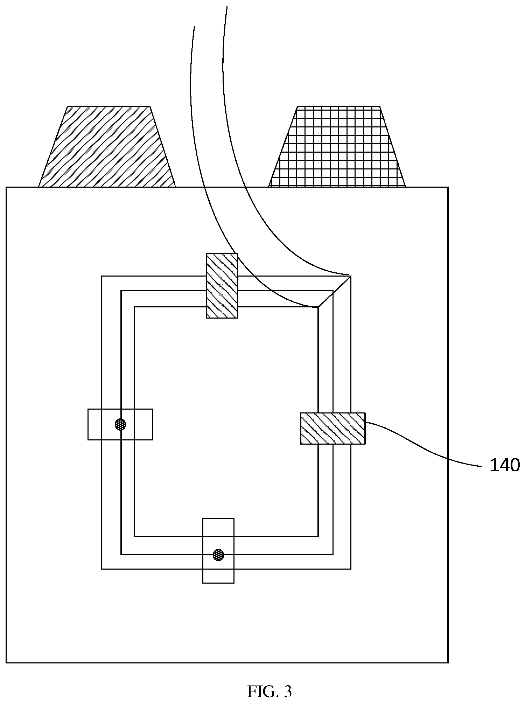

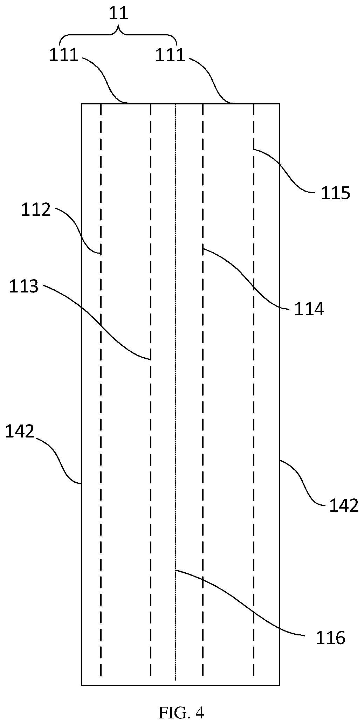

Please refer to FIG. 1 to FIG. 4, FIG. 1 is a schematic diagram of a front view structure of a power battery according to the embodiments of the present disclosure, FIG. 2 is a schematic diagram of one side structure of the power battery shown in FIG. 1, FIG. 3 is a schematic diagram of a fixed structure of an electrode sheet sensor of the power battery shown in FIG. 2, and FIG. 4 is a schematic diagram of another side structure of the power battery shown in FIG. 1. In the embodiment of the present disclosure, the power battery 100 includes a cell pack 11, an expansion force sensor 12 and an electrode sheet sensor 13.

The cell pack 11 includes a cell 111 and tabs 112 extending out from the cell 111. According to the number of the cell pack 11, the power battery 100 may be a single-cell pack battery, a dual-cell pack battery, or a multi-cell pack battery. A manufacturing process of the cell pack 11 includes winding and stacking methods, etc. If not otherwise specified, the following description will take the structure in which the cell pack 11 includes one cell 111 as an example.

The cell 111 includes electrode sheets (not shown). During the use of the cell 11, the thickness of the electrode sheets will change, and the thickness of a negative electrode sheet will change more obviously. Batteries, especially lithium batteries, are prone to swelling after long-term storage and circulation. Due to the influence of a graphite anode, compounds such as LiCx will be generated during a lithium intercalation process of the graphite anode, causing lattice changes between molecules and generating microscopic internal stress, which will lead to partial swelling at the graphite anode end. In addition, the binder and the electrolyte also affect thickness variations of the electrode sheets. During charging, lithium ions migrate from the cathode and embed into the anode, causing the graphite anode lattices to expand. The deformation of the anode particles and the binder releases internal stress at the anode, resulting in an increased expansion rate of the battery anode. The thickness variations of the positive electrode sheet and the negative electrode sheet of the battery will directly affect the performance and health of the cell. Therefore, it is necessary to monitor the thickness variations of the electrode sheets to guide the thickness scheme of the cell, so as to achieve a cell with optimal performance.

The expansion force sensor 12 is electrically connected to the cell 111, and is configured to collect expansion forces at different thickness positions of the cell 111, and assesses the health state of the power battery according to the expansion forces.

The electrode sheet sensor 13 is electrically connected to the cell 111, and is configured to collect thicknesses of the electrode sheets at different thickness positions of the cell 111, and assesses the health state of the power battery according to the thicknesses of the electrode sheets.

Therefore, in this embodiment, the expansion forces and the thicknesses of the electrode sheets at different thickness positions of the cell can be respectively collected by a plurality of sensors to evaluate the health state of the battery, so that the safety state of the cell can be monitored in real time and comprehensively, thereby reducing a safety risk of the cell.

Optionally, the power battery 100 includes a housing 14, and the cell 111 is arranged in the housing 14. The housing 14 may be a rolled square aluminum shell, a cylinder, a laminated square aluminum shell, or the like. When the cell 111 expands due to to heating or other reasons, an internal pressure of the cell 111 is too high, and in this embodiment, the pressure caused by the internal expansion of the cell is collected to collect the expansion force of the cell 111. Specifically, the expansion force of the thicknesses of the electrode sheets inside the cell 111 may be collected as the expansion force of the cell 111.

Optionally, the expansion force sensor 12 includes multiple groups of first collection harnesses 121 and a first processor (not shown in the figure) electrically connected to the first collection harnesses 121. The multiple groups of first collection harnesses 121 are respectively arranged on different side surfaces of the housing 14, and the first processor is arranged on a top surface of the housing 14. The multiple groups of first collection harnesses 121 respectively collect the expansion forces at different thickness positions of the cell 111, and transmit the collected expansion forces to the first processor.

Optionally, each group of first collection harnesses 121 include a first sampling harness 1213, a first winding harness 1211, and a first transmission harness 1212. One end of the first sampling harness 1213 is arranged inside the cell 111, and the other end of the first sampling harness 1213 is connected to the first winding harness 1211. The first winding harness 1211 is arranged on the side surface of the housing 14. The first transmission harness 1212 is electrically connected to the first winding harness 1211 and the first processor, respectively, and is configured to transmit the expansion forces.

The first sampling harnesses 1213 of the multiple groups of first collection harnesses 121 are respectively arranged at different thicknesses positions of the cell 111, and the first winding harness 1211 connected to the first sampling harness 1213 is arranged on the nearest side surface of the housing 14 harness.

In a specific embodiment, as shown in FIG. 1, the housing 14 is a cuboid. The top surface 141 of the housing 14 is provided with the first processor, and four side surfaces of the housing 14 include two parallel first side surfaces 142 with a larger area and two parallel second side surfaces 143 with a smaller area. As shown in FIG. 4, when two cells 111 are included, that is, the two cells 111 form a dual-cell pack battery, the first sampling harnesses 1213 of the multiple groups of first collection harnesses 121 are respectively arranged at a one-eighth thickness position 112, a three-eighth thickness position 113, a five-eighth thickness position 114, and a seven-eighth thickness position 115 of the dual-cell pack. It should be understood that, these thickness positions refer to thicknesses in a direction from one cell 111 to the other cell 111 after the two cells 111 are stacked. As shown in FIG. 4, the one-eighth thickness position 112 and the seven-eighth thickness position 115 are symmetrical relative to a center line position 116 of the dual-cell pack battery. Similarly, the three-eighth thickness position 113 and the five-eighth thickness position 114 are symmetrical relative to the center line position 116 of the dual-cell pack battery. By collecting the expansion forces at different thickness positions, the internal expansion forces of the cell 111 can be monitored comprehensively, thereby obtaining more accurate expansion force data and achieving accurate monitoring.

Furthermore, because the two first side surfaces 142 with a larger area are located in a direction from one cell 111 to the other cell 111, therefore, the one-eighth thickness position 112 and the seven-eighth thickness position 115 of the cell 111 are closer to the first side surfaces 142, that is, the one-eighth thickness position 112 is close to one of the first side surfaces 142, and the seven-eighth thickness position 115 is close to the other of the first side surfaces 142. Thus, the first winding harnesses 1211, which are electrically connected to the first sampling harnesses 1213 at the one-eighth thickness position 112 and the seven-eighth thickness position 115, are arranged on the corresponding first side surfaces 142 according to a proximity principle. That is, the first sampling harnesses 1213 at the one-eighth thickness position 112 and the seven-eighth thickness position 115 are electrically connected to the first winding harnesses 1211 on the first side surfaces 142. Similarly, the three-eighth thickness position 113 and the five-eighth thickness position 114 of the cell 111 are closer to the second side surfaces 143, that is, the three-eighth thickness position 113 is close to one of the second side surfaces 143, and the five-eighth thickness position 114 is close to the other of the second side surfaces 143. Thus, the first winding harnesses 1211, which are electrically connected to the first sampling harnesses 1213 at the three-eighth thickness position 113 and the five-eighth thickness position 114, are arranged on the corresponding second side surfaces 143 according to the proximity principle. That is, the first sampling harnesses 1213 at the three-eighth thickness position 113 and the five-eighth thickness position 114 are electrically connected to the first winding harnesses 1211 on the second side surfaces 143.

Optionally, the first winding harness 1211 includes multiple turns of winding wires. The winding wire in the middle is provided with multiple data collection points 123, i.e., expansion force collection points that are evenly and symmetrically distributed. The first transmission wire 1212 is electrically connected to the data collection points 123 of the winding wire to transmit expansion force.

In a specific embodiment, the first winding harness 1211 can include three turns of rectangular winding wires, respectively winding wires 1211A, 1211B, and 1211C, with the winding wire 1211B arranged in the middle. Rectangular centers of the winding wires 1211A, 1211B, and 1211C coincide with each other, and a center position of each of the winding wires 1211A, 1211B, and 1211C coincides with a center position of the side surface on which the winding wire is arranged. The length and width of the rectangle of the largest rectangular winding wire, i.e., the winding wire 1211A, respectively account for about one-half of the length and width of its bearing surface. For example, a diagonal intersection of the winding wire on the first side surface 142 coincides with the diagonal lines of the first side surface 142. The expansion force collection points are arranged on the second-turn winding wire 1211B, are respectively arranged at midpoints of the four sides of the square second-turn winding wire 1211B, and are symmetrically distributed. The first transmission harness 1212 on the first side surface 142 is led out from the first side surface 142 at a position close to the top surface 141.

For another example, a diagonal intersection of the winding wire on the second side surface 143 coincides with the diagonal lines of the second side surface 143. The expansion force collection points are arranged on the second-turn winding wire and are symmetrically distributed. The first transmission harness 1212 on the second side surface 143 is led out from the second side surface 143 at a position close to the top surface 141.

Optionally, the first winding harness 1211 may be fixed by using green high temperature adhesive tapes 150, and specifically may be fixed at a middle position of four sides of the first winding harness 1211 of the rectangular structure. The size of the high temperature adhesive tape is about 5 mm * 130 mm.

Optionally, the electrode sheet sensor 13 includes a second collection harness 131 and a second processor (not shown in the figure) electrically connected to the second collection harness 131. The second processor is arranged on the top surface 141 of the housing. The second collection harness 131 respectively collects thicknesses of the electrode sheets at different thickness positions of the cell 111, and transmits the collected thicknesses of the electrode sheets to the second processor.

Optionally, the second collection harness 131 includes a second winding harness 1311, multiple groups of second sampling harnesses 1312, and a second transmission harness 1313. One ends of the multiple groups of second sampling harnesses 1312 are respectively arranged at different thicknesses positions of the cell 111, and the other ends of the second sampling harnesses 1312 are connected to the second winding harness 1311. The second winding harness 1311 is arranged on a side surface of the cell 111 and located in a region outside a thinning region of the electrode sheets. The second transmission harness 1313 is electrically connected to the second winding harness 1311 and the second processor, respectively, and is configured to transmit the thicknesses of the electrode sheets.

In a specific embodiment, as shown in FIG. 2, when two cells 111 are included, that is, the two cells 111 form a dual-cell pack battery, the second winding harness 1311 is arranged between the two cells 111, and the second transmission harness 1313 is led out upwards from the middle of the two cells, and further led out from the middle of two taps 112. The second sampling harnesses 1312 include four groups, and one ends of the four groups of second sampling harnesses 1312 are respectively arranged at the one-eighth thickness position 112, the three-eighth thickness position 113, the five-eighth thickness position 114, and the seven-eighth thickness position 115 of the dual-cell pack. By collecting the thicknesses of the electrode sheets at different thickness positions, the electrode sheets of the cell 111 can be monitored comprehensively, thereby obtaining more accurate thickness data of the electrode sheets, and achieving accurate monitoring. Further, the other ends of the four groups of second sampling harnesses 1312 are electrically connected to the second winding harnesses 1311 located between the two cells 111 to achieve data output.

Optionally, the second winding harness 1311 includes multiple turns of winding wires. The winding wire in the middle is provided with multiple data collection points 133, i.e., thickness collection points of the electrode sheets that are evenly and symmetrically distributed. The second transmission harness 1313 is electrically connected to the data collection points 133 of the winding wire to transmit the thickness of the electrode sheets.

In a specific embodiment, the second winding harness 1311 can include three turns of rectangular winding wires, respectively winding wires 1311A, 1311B, and 1311C, with winding wire 1311B arranged in the middle. Rectangular centers of the winding wires 1311A, 1311B, and 1311C coincide with each other, and a center position of each of the winding wires 1311A, 1311B, and 1311C coincides with a center position of the side surface on which the winding wire is arranged. The length and width of the rectangular of the largest rectangular winding wire, i.e., the winding wire 1311A, respectively account for about one-half of the length and width of its bearing surface. The thickness collection points of the electrode sheets are arranged on the second-turn winding wire 1311B, are sequentially distributed on each rectangular side, and are symmetrically distributed.

Further, as shown in FIG. 3, the second winding harness 1311 may be fixed by using green high temperature adhesive tapes 140, and specifically may be fixed at a middle position of four sides of the second winding harness 1311 of the rectangular structure. The size of the high temperature adhesive tape is about 5 mm * 130 mm.

Optionally, the top surface 141 of the housing 14 is provided with a liquid injection hole 144, a positive pole 145 and a negative pole 146. A circular hole 147 is provided at a position between the liquid injection hole 144 and the positive pole 145. The first transmission harness 1212 and the second transmission harness 1312 are led out from the circular hole 147, and are connected to the first processor and the second processor, so as to analyze data and predict an abnormal swelling thickness of the cell in advance.

In this embodiment, the expansion force sensor 12 and the electrode sheet sensor 13 may be optical fiber sensors. The first collection harness 121 and the second collection harness 131 may be optical fiber harnesses of the optical fiber sensors, and the first processor and the second processor may be chips of the optical fiber sensors. Furthermore, the optical fiber harness may be led out from the circular hole 147 after passing through a silicone sealing sleeve. The optical fiber harness may also be packaged in a form such as a sealing ring. Furthermore, the chip of the sensor may be connected to a server in a wireless or wired manner. Thus, after receiving the corresponding data (the expansion forces of the cell and the thicknesses of the electrode sheets), a server terminal can perform big data analysis to monitor whether problems such as over temperature and battery expansion occur in the cell 111. The server terminal may be a module terminal, a vehicle-mounted service terminal, a server terminal of the energy storage integrated box, a cloud terminal, etc.

Therefore, the expansion forces of the cell and the thicknesses of the electrode sheets of the cell can be respectively collected by a plurality of sensors to evaluate the health state of the battery, so that the safety state of the cell can be monitored in real time, thereby reducing a safety risk of the cell.

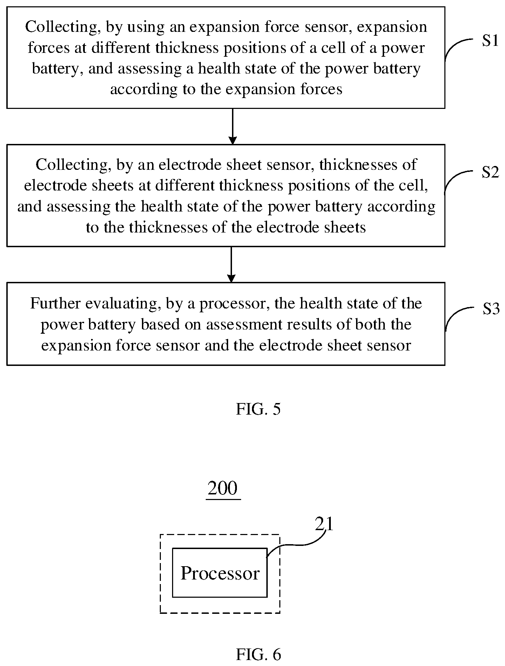

The embodiment of the present disclosure further provides a health evaluation method of a power battery based on the power battery 100 described above. Please refer to FIG. 5, FIG. 5 is a schematic flowchart of a health evaluation method of a power battery according to the embodiments of the present disclosure. The power battery includes the power battery 100 described above. As shown in FIG. 5, the health evaluation method of the present embodiment includes the following steps:

Step S1, collecting, by using an expansion force sensor, expansion forces at different thickness positions of a cell of the power battery, and assessing a health state of the power battery according to the expansion forces.

This step can determine whether the expansion force is greater than an expansion force threshold value. If yes, a health abnormality of the power battery is assessed.

The expansion forces at different thickness positions of the cell of the power battery may be collected by the expansion force sensor, and then the health abnormality of the power battery is assessed according to the expansion forces at different positions.

In a specific embodiment, when two cells are included, that is, the two cells 111 form a dual-cell pack battery, the expansion force sensor can respectively collect the expansion forces at one-eighth thickness position, three-eighth thickness position, five-eighth thickness position, and seven-eighth thickness position of the dual-cell pack battery. By collecting the expansion forces at different thickness positions, the internal expansion force of the cell can be monitored comprehensively, thereby obtaining more accurate expansion force data and achieving accurate monitoring. The specific collection process is as described above, and will not be repeated herein.

Step S2, collecting, by an electrode sheet sensor, thicknesses of electrode sheets at different thickness positions of the cell, and assessing the health state of the power battery according to the thicknesses of the electrode sheets.

In this step, it may be determined whether the thickness of the electrode sheet is greater than an electrode sheet thickness threshold value. If yes, the health abnormality of the power battery is assessed. Furthermore, research and development personnel can be guided to redesign the thickness of a chip according to a change in the thickness of an electrode sheet, so that the thickness of the chip better meets use requirements of the cell.

In one embodiment, the thicknesses of the electrode sheets at different thickness positions of the cell of the power battery may be collected by the electrode sheet sensor.

In a specific embodiment, when two cells 111 are included, that is, the two cells form a dual-cell pack battery, the electrode sheet sensor can respectively collect the thicknesses of the electrode sheet at the one-eighth thickness position, the three-eighth thickness position, the five-eighth thickness position, and the seven-eighth thickness position of the dual-cell pack battery. By collecting the thicknesses of the electrode sheets at different thickness positions, the thicknesses of the electrode sheets inside the cell can be monitored comprehensively, thereby obtaining more accurate thickness data of the electrode sheets, and achieving accurate monitoring. The specific collection process is as described above, and will not be repeated herein.

Step S3, further evaluating, by a processor, the health state of the power battery based on assessment results of both the expansion force sensor and the electrode sheet sensor.

The processor may further evaluate the health state of the power battery based on the assessment results of the above-described various sensors. The above-described sensors only simply assesses the abnormality of the corresponding parameters, which causes abnormal health state of the power battery, but does not perform a comprehensive evaluation. In this step, the health state of the battery can be comprehensively determined by summarizing the assessment results of various sensors. Specifically, corresponding health levels can be set for the assessment results of the expansion force sensor and the electrode sheet sensor, that is, the health state of the power battery can be classified into levels, with each parameter corresponding to a health level, for example, the expansion forces corresponds to a first health level of the power battery, and the thickness variation of the electrode sheets corresponds to a second health level. Different health levels correspond to different levels of urgency in handling.

The processor analyzes the assessment result of each sensor to obtain a corresponding health level of the power battery. If there are multiple health levels, they will be handled according to the highest health level. Specifically, if both the expansion force sensor and the electrode sheet sensor assess that the power battery is in an abnormal health state, the processor will process it according to the highest level state, i.e., the first level health state corresponding to the expansion forces, and prompt operators that special emergency treatment is required. For another example, if only the electrode sheet sensor evaluates that the power battery is in an abnormal health state, the operator will be prompted for general handling. It should be understood that a comprehensive evaluation manner of the processor is not limited to the technical solutions introduced above.

Please refer to FIG. 6, which is a schematic block diagram of a health evaluation device 200 of a power battery according to the embodiments of the present disclosure. The power battery includes the power battery 100 as described above. As shown in FIG. 6, the health evaluation device 200 of the present embodiment includes a processor 21. The processor 21 is configured to further evaluate the health state of the power battery based on the assessment results of both the expansion force sensor 12 and the electrode sheet sensor 13.

The processor 21 may further evaluate the health state of the power battery based on the assessment results of the above-described various sensors. The above-described sensor only simply assesses the abnormality of the corresponding parameter, which causes the abnormal health state of the power battery, but does not perform a comprehensive evaluation. In this step, the health state of the battery can be comprehensively determined by summarizing the assessment results of various sensors. Specifically, corresponding health levels can be set for the assessment results of the expansion force sensor and the electrode sheet sensor, that is, the health state of the power battery can be classified into levels, with each parameter corresponding to a health level, for example, the expansion forces corresponds to a first health level of the power battery, and the thickness variation of the electrode sheets corresponds to a second health level. Different health levels correspond to different levels of urgency in handling.

The processor 21 analyzes the assessment result of each sensor to obtain a corresponding health level of the power battery. If there are multiple health levels, they will be handled according to the highest health level. Specifically, if both the expansion force sensor and the electrode sheet sensor assess that the power battery is in an abnormal health state, the processor will process it according to the highest level state, i.e., the first level health state corresponding to the expansion forces, and prompt operators that special emergency treatment is required. For another example, if only the electrode sheet sensor evaluates that the power battery is in an abnormal health state, the operator will be prompted for general handling. It should be understood that a comprehensive evaluation manner of the processor is not limited to the technical solutions introduced above.

In summary, the present disclosure provides a power battery and a health evaluation method thereof. The power battery includes a power battery that includes a cell, an expansion force sensor and an electrode sheet sensor. The cell includes electrode sheets. The expansion force sensor is electrically connected to the cell, and is configured to collect expansion forces at different thickness positions of the cell, and assess a health state of the power battery according to the expansion forces. The electrode sheet sensor is electrically connected to the cell, and is configured to collect thicknesses of the electrode sheets at different thickness positions of the cell, and assess the health state of the power battery according to the thickness of the electrode sheets. Therefore, the expansion forces of the cell and the thicknesses of the electrode sheets of the cell can be respectively collected by a plurality of sensors to evaluate the health state of the battery, so that the safety state of the cell can be monitored in real time, thereby reducing a safety risk of the cell.

Various technical features of the foregoing embodiments may be combined arbitrarily. To make the description brevity, not all possible combinations of the technical features in the above embodiments have been described. However, as long as there is no contradiction in the combination of these technical features, they should be considered to be within the scope of this specification.

## Claims

1. A power battery, the power battery comprising a cell, an expansion force sensor and an electrode sheet sensor, wherein,
the cell comprises electrode sheets;
the expansion force sensor is electrically connected to the cell, and is configured to collect expansion forces at different thickness positions of the cell, and assess a health state of the power battery according to the expansion forces;
the electrode sheet sensor is electrically connected to the cell, and is configured to collect thicknesses of the electrode sheets at different thickness positions of the cell, and assess the health state of the power battery according to the thicknesses of the electrode sheets.

2. The power battery according to claim 1, wherein the power battery comprises a housing configured to accommodate the cell; the expansion force sensor comprises multiple groups of first collection harnesses and a first processor electrically connected to the first collection harnesses; wherein the multiple groups of the first collection harnesses are respectively arranged on different side surfaces of the housing; the first processor is arranged on a top surface of the housing; the multiple groups of first collection harnesses respectively collect the expansion forces at different thickness positions of the cell, and transmit the collected expansion forces to the first processor.

3. The power battery according to claim 2, wherein each group of first collection harnesses comprises a first sampling harness, a first winding harness, and a first transmission harness; wherein one end of the first sampling harness is arranged inside the cell, and the other end of the first sampling harness is electrically connected to the first winding harness; the first winding harness is arranged on the side surface of the housing; the first transmission harness is electrically connected to the first winding harness and the first processor, respectively, and is configured to transmit the expansion forces.

4. The power battery according to claim 3, wherein one ends of the first sampling harnesses of the multiple groups of first collection harnesses are respectively arranged at different thicknesses positions of the cell, and the first winding harness connected to the first sampling harness is arranged on a side surface of the housing closest thereto.

5. The power battery according to claim 3 or 4, wherein the electrode sheet sensor comprises a second collection harness and a second processor electrically connected to the second collection harness; the second processor is arranged on the top surface of the housing; the second collection harness respectively collects the thicknesses of electrode sheets at different thickness positions of the cell, and transmits the collected thicknesses of the electrode sheets to the second processor.

6. The power battery according to claim 5, wherein the second collection harness comprises a second winding harness, multiple groups of second sampling harnesses, and a second transmission harness; wherein one ends of the multiple groups of second sampling harnesses are respectively arranged at different thicknesses positions of the cell, and the other ends of the second sampling harnesses are electrically connected to the second winding harness; the second winding harness is arranged on a side surface of the cell and located in a region outside a thinning region of the electrode sheets; the second transmission harness is electrically connected to the second winding harness and the second processor, respectively, and is configured to transmit the thicknesses of the electrode sheets.

7. The power battery according to claim 6, wherein each of the first winding harness and the second winding harness comprises multiple turns of winding wires; wherein the winding wire in the middle is provided with multiple data collection points that are evenly and symmetrically distributed; the first transmission harness and the second transmission harness are respectively electrically connected to corresponding data collection points of the winding wire to transmit the expansion force and the thickness of the electrode sheets.

8. The power battery according to claim 6, wherein each of the first winding harness and the second winding harness comprises multiple turns of winding wires; wherein a central position of each winding wire coincides with a central position of the side surface on which the winding wire is arranged.

9. A health evaluation method of a power battery, wherein the power battery comprises the power battery of any one of claims 1 to 8; the health evaluation method comprises:
collecting, by using an expansion force sensor, expansion forces at different thickness positions of a cell of the power battery, and assessing a health state of the power battery according to the expansion forces;
collecting, by an electrode sheet sensor, thicknesses of electrode sheets at different thickness positions of the cell, and assessing the health state of the power battery according to the thicknesses of the electrode sheets; and
further evaluating, by a processor, the health state of the power battery based on assessment results of both the expansion force sensor and the electrode sheet sensor.

10. The health evaluation method according to claim 9, wherein the further evaluating, by a processor, the health state of the power battery based on assessment results of both the expansion force sensor and the electrode sheet sensor comprises:
setting corresponding health levels for the assessment results of the expansion force sensor and the electrode sheet sensor; and
analyzing, by the processor, the health level corresponding to the expansion force sensor and the health level corresponding to the electrode sheet sensor to obtain a corresponding health level of the power battery.

11. A health evaluation device of a power battery, wherein the power battery comprises the power battery of any one of claims 1 to 8; the health evaluation device comprises a processor configured to further assess a health state of the power battery according to assessment results of an expansion force sensor and an electrode sheet sensor.
